Europäisches Patentamt

European Patent Office

Office européen des brevets

(19)

(11) Numéro de publication : **0 206 844 B1**

# FASCICULE DE BREVET EUROPEEN

(12)

(45) Date de publication du fascicule du brevet :
02.01.91 Bulletin 91/01

(51) Int. Cl.⁵ : **G06F 11/26**, G11C 17/00,
G11C 29/00

(21) Numéro de dépôt : 86400870.1

(22) Date de dépôt : 22.04.86

(54) **Mémoire morte programmable électriquement une seule fois.**

(30) Priorité : 26.04.85 FR 8506444

(43) Date de publication de la demande :
30.12.86 Bulletin 86/52

(45) Mention de la délivrance du brevet :
02.01.91 Bulletin 91/01

(84) Etats contractants désignés :
DE GB IT

(56) Documents cités :
EP-A- 0 078 502
DE-A- 3 232 215
US-A- 4 320 507

(73) Titulaire : SGS-THOMSON
MICROELECTRONICS S.A.
7, Avenue Galliéni
F-94250 Gentilly (FR)

(72) Inventeur : Fruhauf, Serge
c/o Thomson-CSF SCPI 19, avenue de
Messine
F-75008 Paris (FR)
Inventeur : Gaultier, Jean-Marie
c/o Thomson-CSF SCPI 19, avenue de
Messine
F-75008 Paris (FR)

(74) Mandataire : Schmit, Christian Norbert Marie
et al
Cabinet Ballot-Schmit 7, rue Le Sueur
F-75116 Paris (FR)

## Description

L'invention a pour objet une mémoire morte programmable électriquement une seule fois. Elle concerne plus particulièrement les mémoires dont le point mémoire comporte un transistor à deux grilles : une grille flottante et une grille de commande. La programmation de la mémoire s'obtient en injectant des charges sur les grilles flottantes des transistors : elles y restent emprisonnées. Selon que des charges ont été injectées ou non, le transistor d'un point mémoire se comporte comme un circuit ouvert ou fermé quand une impulsion électrique est envoyée sur sa grille de commande. Il révèle alors un état logique un ou un état logique zéro.

Les mémoires mortes programmables électriquement sont généralement utilisées pour remplir des fonctions de calcul numérique. A des séries d'impulsions électriques introduites en entrée, en adresse, la mémoire réagit en délivrant en sortie des informations numériques sous forme d'impulsions. Celles-ci correspondent aux informations stockées dans les points mémoire et à la fonction en question. Une telle mémoire, qui à l'origine est prévue pour pouvoir remplir une fonction quelconque, est donc figée dans une application précise imposée par l'utilisateur. Le souhait des utilisateurs est que les informations stockées ne soient plus modifiées. Pour éviter que le travail de programmation engagé ne soit perdu, les mémoire concernées sont pourvues d'un dispositif empêchant leur effacement. En pratique, l'effacement de la mémoire s'obtient par expulsion des charges piègées dans les grilles flottantes. Ceci peut être obtenu par exposition de la mémoire à un rayonnement ultra-violet. Le dispositif qui empêche cet effacement est tout simplement un écran opaque placé lors de la construction au dessus du plan des points mémoire de la mémoire. Cet écran opaque est constitué par un boîtier hermétique. Contrairement aux mémoires effaçables et reprogrammables ce boîtier, ici, ne comporte pas de fenêtre en quartz.

Avant d'être vendus, les circuits intégrés réalisés selon cette technologie doivent être testés. Parmi les tests engagés il en est un qui sert à élaborer le prix de vente de la mémoire testée. Ce test est le tri en vitesse. Il consiste à répartir les différentes mémoires fabriquées en des lots différenciés selon la durée du temps de réponse entre une impulsion de commande de lecture et la sortie effective des informations stockées dans la mémoire. Ce tri en vitesse doit être pratiqué en vraie grandeur. Ceci signifie qu'il doit concerner des points mémoire programmés. Or, par sa conception, la mémoire morte programmable électriquement une seule fois doit être vendue vierge au client. Pour mener à bien ce tri on est donc conduit à réaliser, dans le plan des points mémoire, des points mémoire supplémentaires que l'on programme et sur lesquels on effectue ultérieurement et après encapsulation les tests pour mettre en évidence les caractéristiques de la mémoire fabriquée.

Dans la pratique les points mémoire d'une mémoire sont répartis matriciellement en rangées et en colonnes. Les points mémoire supplémentaires sont alors alignés selon une rangée, ou une colonne. Le problème à résoudre est d'accéder à cette rangée supplémentaire : d'une part pour la programmer et d'autre part pour effectuer le tri en vitesse. L'accès à un point mémoire d'une mémoire est obtenu au moyen de circuits de décodage : les décodeurs. Ceux-ci reçoivent les adresses et établissent des connexions avec la rangée et la colonne aboutissant a un point mémoire recherché. Une adresse à $\underline{n}$ moments permet de discriminer un point mémoire parmi $2^n$ points mémoire répartis dans le plan. Autrement dit la capacité d'une mémoire est liée au nombre de moments du mot d'adressage avec lequel elle fonctionne.

Pour accéder à la rangée des points mémoire supplémentaires il est possible d'envisager deux techniques. Une première technique consiste à augmenter la puissance du décodeur : en devenant capable de traiter n+1 moments on peut accéder à la rangée ou la colonne des points mémoire supplémentaires. Cette solution revient à doubler la puissance du décodeur et revient à faire fonctionner ultérieurement la mémoire avec un mot d'adressage plus long qu'il n'est vraiment nécessaire. Une autre solution consiste à réaliser une connexion spécialisée qui aboutit à la rangée des points mémoire supplémentaires. Avec cette connexion supplémentaire et avec le décodeur colonne on peut effectuer la programmation puis, ultérieurement, les tests sur la rangée des points mémoire supplémentaires. Il apparaît alors un problème relatif au tri en vitesse. La sélection de la rangée supplémentaire par la connexion spécialisée ne s'effectue pas à la même vitesse que quand la mémoire fonctionne normalement. En effet, en fonctionnement normal, les impulsions électriques d'adresse transitent par le décodeur rangée avant de sélectionner une rangée donnée. Ce passage au travers du décodeur est plus lent que la simulation de commande par la connexion spécialisée. Autrement dit pour le tri en vitesse pratiqué de cette manière on évalue le temps de réponse sans tenir compte des performances du décodeur rangée. On n'est donc pas sûr de la qualité vraie à cet égard de la mémoire testée. Une première solution est par exemple visible sur le document US-A-4 320 507. Cependant dans ce document, la performance de vitesse égale n'est obtenue, en définitive, qu'en ralentissant l'utilisation de la mémoire en mode normal.

L'invention a pour objet de remédier à ces inconvénients en proposant une mémoire du même type où, d'une part, on mesure le temps de réponse vrai et où, d'autre part, il n'est pas nécessaire de prévoir un moment supplémentaire dans l'adressage. On affecte tout simplement à la rangée supplémentaire de points mémoire une adresse rangée identique à celle d'une autre rangée de points mémoire du plan des points mémoire. Lors de la programmation et du test de cette rangée supplémentaire, on utilise le décodeur rangée normalement pour sélectionner les deux rangées ainsi repérées. Avec la connexion spécialisée on valide la sélection de la rangée supplémentaire et on invalide la sélection de la rangée normale appairée à cette rangée supplémentaire.

L'invention concerne une mémoire morte programmable électriquement une seule fois du type comportant :

- des points mémoire à programmer répartis matriciellement,

- deux décodeurs dits rangée et colonne pour décoder des signaux d'adressage et pour accéder aux points mémoire par un jeu de connexions rangée et par un jeu de connexions colonne reliées à des sorties de ces décodeurs,

- au moins une connexion supplémentaire pour accéder à une rangée supplémentaire de points mémoire,

- et des moyens pour sélectionner cette rangée supplémentaire à l'exclusion de toutes les autres,

- une sortie dédoublée d'une des sorties du décodeur rangée, cette sortie dédoublée étant affectée à cette rangée supplémentaire, caractérisée en ce qu'elle comporte :

- un post décodeur pour assister le décodeur, ce post décodeur commandant des sélecteurs,

- chaque sélecteur étant destiné à sélectionner des connexions rangées parmi un ensemble de connexions, rangées auxquelles il est raccordé et qui sont concernées par une sortie du décodeur rangée à laquelle ce sélecteur est raccordé,

- un sélecteur dit supplémentaire raccordé à cette sortie dédoublée et à cette rangée supplémentaire,

- le sélecteur de cette rangée supplémentaire comportant des moyens pour être validé.

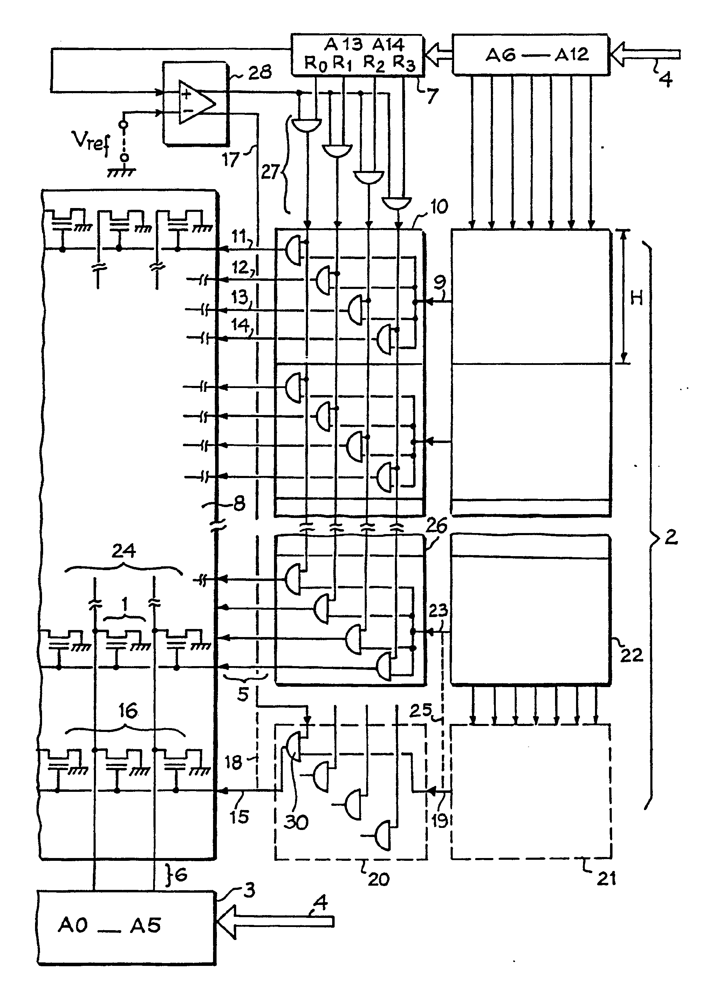

La presente invention sera mieux comprise à la lecture de la description qui suit et à l'examen de la figure qui l'accompagne. Celles-ci sont données à titre indicatif et nullement limitatif de l'invention. La figure représente un diagramme de la structure d'une mémoire conforme à l'invention.

La figure représente une mémoire munie de points mémoire tels que 1 répartis matriciellement. On peut accéder à ces points mémoire en décodant dans deux décodeurs rangée 2 et colonne 3 des signaux d'adressage 4. Ces signaux d'adressage sont introduits en série ou en parallèle dans les décodeurs. Dans un exemple ils comportent 15 moments cotés de A0 à A14. Les décodeurs 2 et 3 permettent d'accéder aux points mémoire respectivement par des jeux 5 et 6 de connexions rangée et de connexions colonne. Le décodeur rangée 2 est ici assisté d'un post-décodeur 7. La raison de cette architecture réside dans l'encombrement du décodeur 2. En effet, même si celui-ci ne décode que six moments, de A6 à A12, la hauteur H nécessaire en implantation mémoire pour discriminer une sortie correspond sensiblement à la hauteur qu'occupent dans le plan mémoire 8 quatre rangées de points mémoire : les rangées 11 à 14. Quatre rangées correspondent justement à deux moments, A13 et A14, puisque le couple de deux moments correspond à quatre valeurs (00, 01, 10, 11) qui permettent de discriminer quatre sorties. Le post-décodeur 7 décode donc ces deux moments A13 et A14. Aussi en aval de chaque sortie 9 du décodeur est placé un sélecteur 10. Celui-ci reçoit des ordres de sélection du post-décodeur 7. Il permet la transmission de cette sélection sur une de ses quatre sorties 11 à 14. Le post-décodeur 7 comporte quatre sorties cotées $R_0$ à $R_3$ : à tout instant une seule de ces sorties est à un état un pour valider une sortie correspondante du sélecteur 10. Les autres sorties sont à un état zéro pour invalider les autres sorties du sélecteur 10. Le sélecteur 10 comporte donc quatre portes ET qui reçoivent toutes sur une de leurs entrées le signal délivré par la sortie 9 du décodeur correspondant à ce sélecteur. Sur leur autre entrée elles reçoivent le signal provenant de chacune des quatre sorties $R_0$ à $R_3$ du post-décodeur 7.

La mémoire comporte encore une connexion supplémentaire 15 pour accéder à une rangée supplémentaire 16 de points mémoire. Une connexion spécialisée 17 permet de sélectionner la connexion 15. L'état de la technique cité plus haut est symbolisé ici sous la forme d'une liaison en tirets 18 qui relie la connexion spécialisée 17 à la connexion supplémentaire 15. Dans l'invention cette liaison est supprimée. Une des caractéristiques de l'invention est que le décodeur 2 comporte une sortie 19 dite dédoublée, affectée à la rangée 16. Un sélecteur supplémentaire 20 reçoit un ordre de sélection délivré par la sortie 19 et un ordre de validation délivré par la connexion spécialisés 17. La validation s'effectue dans une porte ET 30. Le sélecteur 20 validé sélectionne alors la connexion supplémentaire 15.

La sortie 19 est la sortie d'un circuit élémentaire de décodage du décodeur 2 (chaque sortie du décodeur 2 correspond à un circuit de décodage du même type mais différent dans sa fonction de décodage). Dans une réalisation préférée de l'invention, la sortie 19 affectée à la rangée supplémentaire 16 est la sortie d'un circuit élémentaire de décodage supplémentaire 21. Dans ce cas la fonction de décodage de ce circuit supplémentaire 21 est identique à la fonction de décodage d'un autre circuit de décodage 22 auquel il peut être adjacent. Mais on peut se passer du circuit supplémentaire 21 et considérer que la sortie 19 du décodeur, affectée à la rangée supplémentaire 16, est commune avec une sortie 23 d'un circuit de décodage 22. En définitive, ce qui compte c'est que pour une adresse donnée, celle qui correspond au circuit de décodage 22, on puisse sélectionner deux rangées : la rangée supplémentaire 16 et une rangée normale 24.

Comme on a sélectionné ainsi deux rangées par les sorties 23 et 19, ou par la sortie 23 dont une ramification montrée en tirets 25 aboutit au sélecteur supplémentaire 20, on doit maintenant au moyen de la connexion spécialisée 17 valider le fonctionnement du sélecteur 20 et invalider le fonctionnement d'un sélecteur 26 dont une des sorties sélectionne la ligne 24. Pour obtenir ce dernier résultat on utilise des moyens d'invalidation 27 qui étaient déjà mis en oeuvre dans l'état de la technique décrit. Ces moyens 27 comportent quatre portes ET montées en cascade entre le post-décodeur 7 et les sélecteurs du décodeur 2. Ces portes ET reçoivent sur une de leurs entrées un ordre d'invalidation, complémentaire de l'ordre de validation du sélecteur 20, et sur leur autre entrée une des sorties $R_0$ à $R_3$ du post-décodeur 7. L'ordre d'invalidation empêche la transmission d'un état un de l'une quelconque des sorties de ce post-décodeur. En conséquence tous les sélecteurs normaux du décodeur sont invalidés. Seul le sélecteur supplémentaire 20 laisse passer l'ordre de sélection puisqu'il est validé par la connexion 17.

Avec le dispositif de l'invention on constate donc que pour le tri en vitesse, les mots d'adresse 4 transitent par le décodeur 2 pour sélectionner la rangée supplémentaire 16 : la durée de cette transition renseigne véritablement sur les performances de ce décodeur. On peut donc bien avec le dispositif de l'invention faire une partition entre des mémoires fabriquées pour grouper ensemble des mémoires ayant des vitesses de travail comparables.

Dans le fonctionnement normal de la mémoire l'ordre de validation du sélecteur 20 est inversé, de même que l'ordre d'invalidation des moyens 27. Ces deux ordres complémentaires l'un de l'autre, peuvent être délivrés par tous moyens, même par une borne de connexion extérieure à la mémoire. D'une manière préférée ces deux ordres complémentaires sont délivrés par un circuit de comparaison 28. Le circuit de comparaison 28 comporte deux entrées et deux sorties. Les deux sorties sont complémentaires l'une de l'autre elles délivrent les ordres d'invalidation et de validation. Sur une première entrée le comparateur 28 reçoit une tension de référence $V_{réf}$ dont l'amplitude sert de seuil. Sur son autre entrée le comparateur 28 reçoit un des bits du mot d'adressage 4. Pour sélectionner la rangée supplémentaire, le bit du mot d'adressage 4 est introduit dans le comparateur 28 avec un niveau supérieur au niveau habituel. Par exemple si les bits d'adressage peuvent prendre les valeurs O volts ou $V_{cc}$, le bit spécial, qui doit être un bit actif (donc à $V_{cc}$), possède une amplitude supérieure à $V_{cc}$. La tension de comparaison $V_{réf}$ est intermédiaire entre la tension $V_{cc}$ et cette amplitude supérieure du bit spécial. Le comparateur 28 détecte donc un changement de seuil, bascule, et délivre en conséquence les ordres de validation et d'invalidation. Le bit spécial doit être un des bits actifs de l'adresse commune de la rangée supplémentaire 16 et de la rangée normale 24. En résumé lorsque cette adresse est donnée avec des bits dont les niveaux sont normaux la mémoire fonctionne normalement pour sélectionner la rangée 24. Par contre, quand le bit spécial de cette adresse est donnée à un niveau supérieur, la rangée suplémentaire 16 est sélectionnée seule.

L'invention n'est pas réduite à la description précise qui est donnée ici. En effet l'architecture du décodeur 2 avec le post-décodeur 7 et les sélecteurs 10 ou 23 peut être différente. Le moyen essentiel de l'invention réside dans la présence du sélecteur 20 recevant en entrée une sortie du décodeur 2 (commune à une rangée normale et à la rangée supplémentaire) et un ordre de validation par la connexion spécialisé 17. Par ailleurs, lors des tests, un ordre d'invalidation invalide (comme dans l'état de la technique cité) les rangées normales de points mémoire du plan mémoire.

## Revendications

1. Mémoire morte programmable électriquement une seule fois du type comportant :
   – des points mémoire (1) à programmer répartis matriciellement,
   – deux décodeurs dits rangée (2) et colonne (3) pour décoder des signaux (4) d'adressage et pour accéder aux points mémoire par un jeu (5) de connexions rangée et par un jeu (6) de connexions colonne reliées à des sorties (9, 23) de ces décodeurs
   – au moins une connexion supplémentaire (15) pour accéder à une rangée supplémentaire (16) de points mémoire,
   –des moyens (17, 18, 27, 28) pour sélectionner cette rangée supplémentaire à l'exclusion de toutes les autres,
   – une sortie dédoublée d'une des sorties (19, 25) du décodeur rangée, cette sortie dédoublée étant affectée à cette rangée supplémentaire,
   caractérisée en ce que :
   – le décodeur rangée (2) est assisté par un post-décodeur (7), ce post-décodeur commandant des sélecteurs (10, 26),
   – chaque sélecteur étant destiné à sélectionner des connexions rangée (11 - 14) parmi un ensemble de connexions rangée auxquelles il est raccordé et qui sont concernées par une sortie (9) du décodeur rangée auquel ce sélecteur est raccordé,
   – un sélecteur (20) dit supplémentaire raccordé à cette sortie dédoublée et à cette rangée supplémentaire,

– le sélecteur de cette rangée supplémentaire comportant des moyens (30) pour être validé.

2. Mémoire selon la revendication 1, caractérisée en ce que le décodeur rangée (2) comporte des circuits (22) de décodage raccordés à chacune de ses sorties (9,23), un circuit de décodage supplémentaire (21) étant raccordé au sélecteur supplémentaire (20), et ce circuit de décodage supplémentaire ayant une structure identique et répondant à une même fonction de décodage que celui correspondant à une autre sortie donnée.

3. Mémoire selon l'une quelconque des revendications 1 à 2, caractérisée en ce que le sélecteur supplémentaire (20) comporte un comparateur d'amplitude (28) pour produire un ordre de validation de la sélection de cette rangée supplémentaire quand une partie d'un signal d'adressage correspondant à cette rangée supplémentaire et fournie au décodeur avec une amplitude plus élevée qu'une référence donnée ($V_{ref}$).

**Ansprüche**

1. Festwertspeicher mit einmaliger elektrischer Einschreibmöglichkeit, mit

– matrixförmig verteilten Speicherplätzen (1) zum Einschreiben,

– zwei Dekodierern, die als Reihendekodierer (2) und Spaltendekodierer (3) bezeichnet werden, zum Dekodieren von Adressierungssignalen (4) und zum Zugreifen auf Speicherplätze mittels eines Satzes (5) von Reihenanschlüssen und mittels eines Satzes (6) von mit den Ausgängen (9, 23) dieser Dekodierer verbundenen Spaltenanschlüssen,

– mindestens einem zusätzlichen Anschluß (15) zum Zugreifen auf eine zusätzliche Reihe (16) von Speicherplätzen,

– Mitteln (17, 18, 27, 28) zum Auswählen dieser zusätzlichen Reihe unter Ausschluß sämtlicher anderer Reihen,

– einem von den Ausgängen (19, 25) des Reihendekoders abgespalteten Ausgang, der dieser zusätzlichen Reihe zugeordnet ist,
dadurch gekennzeichnet, daß

– der Reihendekodierer (2) von einem Nachdekodierer (7) unterstützt wird, der Selektoren (10, 26) steuert,

– jeder Selektor dazu bestimmt ist, diejenigen Reihenanschlüsse (11 bis 14) aus einer Gesamtheit von Reihenanschlüssen auszuwählen, mit denen er verbundun ist und die auf einen Ausgang (9) des mit ihm verbundenen Reihendekoders bezogen sind,

– ein Selektor (20), der als zusätzlicher Selektor bezeichnet wird, mit dem abgespalten Ausgang und mit der zusätzlichen Reihe verbunden ist,

– der Selektor der zusätzlichen Reihe Mittel (30) zu seiner Validierung umfaßt.

2. Speicher gemäß Anspruch 1, dadurch gekennzeichnet, daß der Reihendekodierer (2) Dekodierschaltungen (22), die mit jedem seiner Ausgänge (9, 23) verbunden sind, und eine zusätzliche Dekodierschaltung (21), die mit dem zusätzlichen Selektor (20) verbunden ist, umfaßt und die zusätzliche Dekodierschaltung eine identische Struktur besitzt und der gleichen Dekodierfunktion entspricht wie die einem anderen gegebenen Ausgang entsprechende Dekodierschaltung.

3. Speicher gemäß einem der Ansprüche 1 bis 2, dadurch gekennzeichnet, daß der zusätzliche Selektor (20) einen Amplitudenkomparator (28) umfaßt, um eine Validierungsreihenfolge bei der Wahl dieser zusätzlichen Reihe zu erzeugen, wenn ein dieser zusätzlichen Reihe entsprechender Teil eines Adressierungssignals mit einer Amplitude, die größer als ein gegebener Bezugspunkt ($V_{ref}$) ist, an den Dekodierer geliefert wird.

**Claims**

1. A read only memory adapted to be programmed once only of the type comprising :

– memory sites (1) to be programmed and arranged in a matrix,

– two decoders as row (2) and column (3) decoders in order to decode addressing signals (4) and in order to access memory sites via a set (5) of row connections and a set (6) of column connections connected to outputs (9 and 23) of such decoders,

– a least one supplementary connection (15) in order to access a supplementary row (16) of memory sites,

– means (17, 18, 27 and 28) in order to select this supplementary row with the exclusion of all others,

– a redoubled output of one of these outputs (19 and 25) of the row decoder, said redoubled output being associated with this supplementary line,
characterized in that

– the row decoder (2) is assisted by a post-decoder (7), said post decoder controlling selectors (10 and 26),

– each selector being destined to select row connections (11 through 14) in a group of row connections, to which it is connected and which are applied to an output (9) of the row decoder to which this selector is connected, and

– a selector (20) as a supplementary selector connected to this redoubled output and this supplementary line,

– the selector of this supplementary row comprising means (30) in order to validate it,

2. The memory as claimed in claim 1, characterized in that the row decoder (2) comprises decoding circuits (22) connected with each of its outputs (9 and 23), a supplementary decoding circuit (21) being connected to the supplementary selector (20) and this decoding circuit having a structure identical and responding to the same decoding function as that corresponding to another given output.

3. The memory as claimed in claim 1 or claim 2, characterized in that the supplementary selector (20) comprises an amplitude comparator (28) in order to produce a validation order for selection of this supplementary row when a part of the addressing signal corresponds to this supplementary row and is supplied to the decoder with an amplitude higher than a given reference ($V_{ref}$).